# EUROPEAN PATENT SPECIFICATION

(11) **EP 4 015 968 B1**
(45) Date of publication and mention of the grant of the patent: **25.09.2024**
(21) Application number: 20215559.4
(22) Date of filing: 18.12.2020
(51) Int. Cl.: F28D 15/02, F28D 1/053, F28F 1/02, H01L 23/427, H05K 7/20, F28F 13/00, F28D 21/00

(54) **COOLING SYSTEMS AND HEAT EXCHANGERS**
KÜHLSYSTEME UND WÄRMETAUSCHER
SYSTÈMES DE REFROIDISSEMENT ET ÉCHANGEURS DE CHALEUR

(43) Date of publication of application: 22.06.2022
(73) Proprietor: Accelsius, LLC, Austin TX 78757 (US)
(72) Inventor: Amalfi, Raffaele Luca, New Providence, NJ New Jersey 07974 (US); Enright, Ryan, Dublin, D16 R9Y5 (IE); Kafantaris, Vasileios, 12136 Athens (GR)
(74) Representative: Hoffmann Eitle

(56) References cited:
- DE-U1- 202007 011 063
- US-A- 4 324 375
- US-A1- 2018 031 333
- US-A1- 2020 331 639

## Description

### TECHNOLOGICAL FIELD

Examples of the disclosure relate to cooling systems and heat exchangers. Some relate to evaporators and heat exchangers as part of cooling systems for data centres comprising a plurality of electronic devices such as servers and other hardware components.

### BACKGROUND

Cooling is essential to enable telecommunications and computing systems to function properly. Efficient cooling systems that consume less energy, reduce any active control and lower costs are therefore advantageous.

US 4,324,375 relates to a spacecraft modular system with two components of a cooling system, allowing for an expanded and a non-expanded configuration according to the preamble of claim 1.

### BRIEF SUMMARY

According to the invention, there is provided a heat exchanger comprising: a plurality of channels configured for flow of working fluid wherein the plurality of channels are configured to move between a non-expanded configuration and an expanded configuration such that, in the non-expanded configuration the plurality of channels are sized so as to allow for movement of the heat exchanger relative to one or more heat sources and in the expanded configuration the plurality of channels are sized so as to restrict movement of the heat exchanger relative to the one or more heat sources, wherein the plurality of channels are configured so that changes in internal pressure of the working fluid causes the plurality of channels to move between the non-expanded configuration and the expanded configuration.

The plurality of channels may be substantially flat.

The plurality of channels may be configured to fit between substantially flat heat sources.

The heat exchanger may be configured so that when the plurality of channels are in the non-expanded configuration and positioned between the one or more heat sources a gap is provided between the heat sources and the plurality of channels.

The heat exchanger may be configured so that when the plurality of channels are in the expanded configuration and positioned between the one or more heat sources the plurality of tubes grip the heat sources.

A thermal interface material may be coupled to the plurality of channels.

The plurality of channels comprise a plurality of internal walls configured to provide a plurality of sub-channels and wherein the plurality of internal walls comprise means for enabling expansion of the internal walls as the plurality of channels are moved between the non-expanded configuration and the expanded configuration. The heat exchanger may comprise at least one header configured to enable cooling of one or more heat sources.

According to various, but not necessarily all, examples of the disclosure there may be provided a cooling system comprising a plurality of heat exchangers as described herein.

The cooling system may be for cooling hardware components.

The cooling system may comprise one or more intermediate heat exchangers comprising a reservoir for storing working fluid.

The reservoir may be coupled to an outlet of the intermediate heat exchanger.

The heat exchangers may be removably coupled to the cooling system.

The cooling system may be coupled to an air-cooling system.

The air-cooling system may comprise one or more fans configured to drive air flow through the air-cooling system towards a two-phase cooling system.

The two-phase cooling system may be configured to enable heat to be recovered from the air-cooling system.

### BRIEF DESCRIPTION

Some examples will now be described with reference to the accompanying drawings in which:
Fig. 1 shows a schematic of an example two-phase cooling system;
Figs. 2A and 2B show a schematic of an example evaporator;
Figs. 3A to 3D show the channels of an example evaporator;
Fig. 4 shows an example cooling system;
Figs. 5A to 5C show an example heat exchanger;
Figs. 6A and 6B show an evaporator coupled to a rack-level manifold and a schematic of quick couplings;
Figs. 7A to 7C show cooling systems for hardware components; and
Figs. 8A and 8B show another cooling system for hardware components.

### DETAILED DESCRIPTION

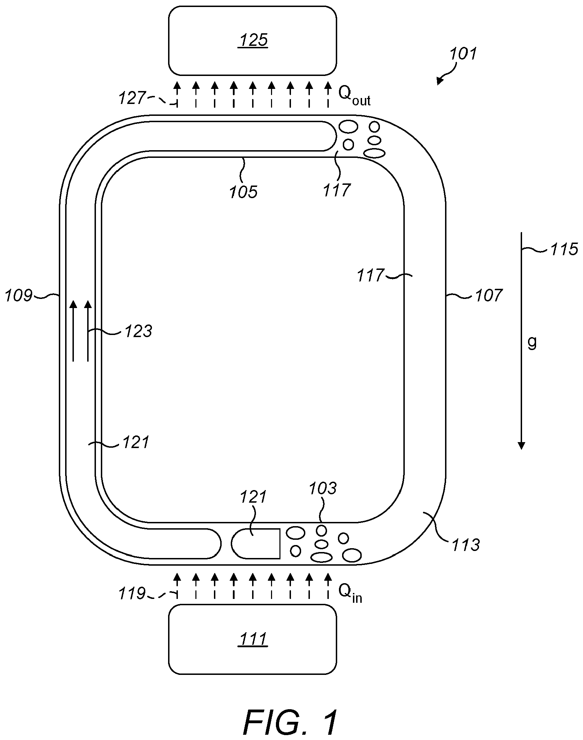

Fig. 1 schematically shows an example of passive two-phase cooling system 101 that can comprise evaporators 103 according to examples of the disclosure. It is to be appreciated that the cooling systems disclosed in this disclosure are also compatible with active single- and two-phase implementations where pumps or other mechanical drivers are used to circulate the working fluid.

In the example of Fig. 1 the two-phase cooling system 101 comprises a thermosyphon loop that is driven by gravity rather than a pump. The example heat exchangers and evaporators 103 disclosed herein can be provided within other types of two-phase cooling system 101 in other examples of the disclosure.

The thermosyphon loop shown in Fig. 1 comprises an evaporator 103, a condenser 105, a downcomer 107 and a riser 109. A working fluid 113 is provided within the thermosyphon loop. When the thermosyphon loop is in use the working fluid 113 circulates through the components of the thermosyphon loop.

The evaporator 103 is provided at the bottom of the thermosyphon loop so that the working fluid flows down the downcomer 107 into the evaporator 103 under the force of gravity as indicated by the arrow 115. The height and inner diameter of the downcomer 107 can be selected to set the driving force of the thermosyphon that causes the fluid to flow through the evaporator 103, riser 109 and condenser 105. The working fluid 113 is in the liquid phase 117 at the inlet of the evaporator 103.

The evaporator 103 comprises any means for transferring heat from a heat source 111 into the working fluid 113. The evaporator 103 is thermally coupled to the heat source 111. A thermal interface material could be used to enable the evaporator 103 to be thermally coupled to the heat source 111. The heat source 111 could comprise an electronic device that generates unwanted heat during operation. The electronic device could be a server, router, network switch, storage device or any other suitable type of device. In some examples the heat sources can comprise a plurality of electronic devices that could provide a data centre, telecommunication equipment room, or network, a communication room, a computer room, a network room or any other suitable arrangement.

Heat is transferred from the heat source 111 to the working fluid 113 in the evaporator 103 as indicated by the arrows 119. This heat transfer causes a partial evaporation of working fluid 113 within the evaporator 103 and converts the working fluid 113 from a liquid phase 117 into a mixture of liquid and vapour phase. In particular, the evaporator 103 causes some of the working fluid 113 to be converted into the vapour phase 121 while some remains in a liquid phase 117 so that the fluid expelled from the outlet of the evaporator 103 is a two-phase mixture. The heat transfer in the evaporator 103 is a combination of sensible and latent heat. The mass fraction of vapor 121 at the outlet of the evaporator 103 is identified by the vapor quality. The two-phase mixture can comprise droplets of vapour entrained within the liquid or other flow regimes depending on the design of the thermosyphon loop, heat load, filling ratio and any other suitable parameter.

The evaporator 103 is coupled to the riser 109 so that the working fluid expelled from the evaporator 103 flows into the riser 109. This working fluid comprises a two-phase mixture where the vapour phase 121 is less dense than the liquid phase 117. The working fluid 113 within the thermosyphon loop rises through the riser 109, as indicated by the arrows 123. The passive flow in the thermosyphon loop is driven by the density difference between the working fluid 113 in the liquid phase in the downcomer 107 and the working fluid 113 in the two-phase mixture in the riser 109.

The evaporator 103 can comprise structures that enable efficient transfer from the evaporator 103 into the working fluid 113. For example, the evaporator 103 could comprise wick structures, micro-channels, arrays of evaporator fins, a serpentine arrangement of macro- / micro-channels or any suitable combination of such features.

The condenser 105 is provided at the top of the thermosyphon loop. The condenser 105 is positioned above the evaporator 103 so that the working fluid 113 flows upwards from the evaporator 103 to the condenser 105.

The condenser 105 is coupled to the riser 109 so that the working fluid 113 in the two-phase mixture (vapour phase 121 and liquid phase 117) flows from the riser 109 into the condenser 105. The condenser 105 can comprise any means for cooling the working fluid 113. For example, the condenser 105 could be air-cooled or liquid-cooled. A liquid-cooled condenser 105 could comprise a tube-in-tube heat exchanger, a shell- and-tube heat exchanger, a plate heat exchanger or any other suitable heat exchanger configuration or arrangement. An air-cooled condenser could comprise a louvered-fin flat tube heat exchanger, a tube-and-fin heat exchanger or any other suitable heat exchanger configuration or arrangement. The condenser 105 can comprise any suitable geometry that enables heat to be removed efficiently from the working fluid.

The condenser 105 is thermally coupled to a coolant 125. A thermal interface material could be used to enable the condenser 105 to be thermally coupled to the coolant 125. The latter implementation can be also used to enable hardware hot-swappability by installing a reworkable thermal interface material that connects the two streams of the condenser 105. In other examples the coolant 125 can be directly integrated in the condenser 105 with a wall interface separating the stream of thermosyphon working fluid 113 from the stream of coolant 125. The wall interface can comprise a highly-conductive metal or metal alloy, such as copper, aluminum, brass, or any other suitable metal. In some examples the wall interface can comprise highly-conductive ceramics such as Aluminum Nitride (AIN), or polymers such as filled polymer composites.

The condenser 105 enables heat to be transferred from the working fluid 113 to the coolant 125 as indicated by the arrows 127. This heat transfer causes the working fluid 113 to condense, at least partly, back into the liquid phase 117. The working fluid 113 at the outlet of the condenser 105 can be therefore in the liquid phase 117 or in the two-phase mixture (vapour phase 121 and liquid phase 117).

The condenser 105 is coupled to the downcomer 107 so that the working fluid 113 can flow down the downcomer 107 by gravity and be returned to the inlet of the evaporator 103.

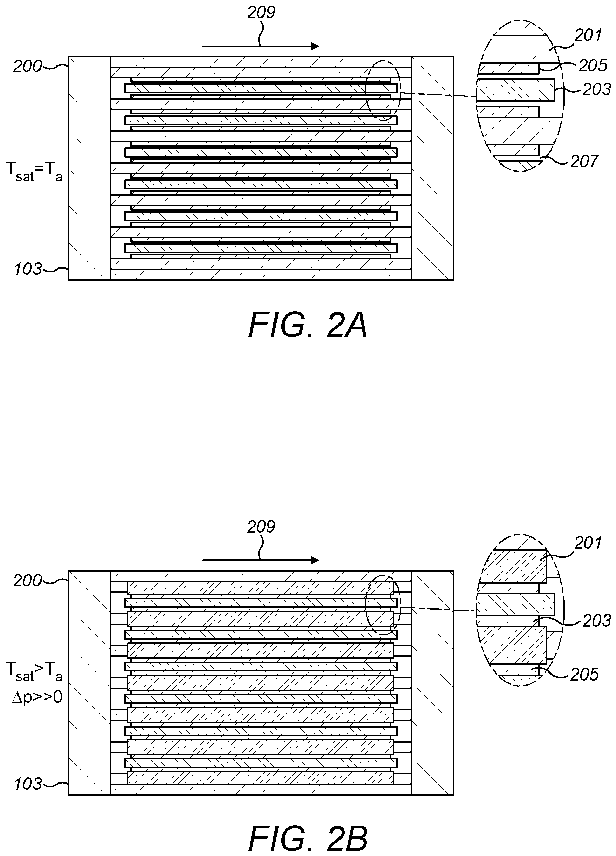

Figs. 2A and 2B schematically show a heat exchanger 200 according to examples of the disclosure. In this example the heat exchanger 200 is an evaporator 103. The evaporator 103 can be used in cooling systems such as the two-phase cooling system 101 shown in Fig. 1. It is to be appreciated that the evaporator 103 shown in Figs. 2A and 2B can be also used in active single- and two-phase cooling systems where pumps or other mechanical drivers are used to circulate the working fluid.

The evaporator 103 can be used to cool memory boards, GPU cards and/or other flat, or substantially flat components of hardware or other heat sources. The components that are being cooled can be used in telecommunications systems, computing systems or any other suitable systems. In the examples of Figs. 2A and 2B the evaporator 103 is shown in position adjacent to the memory boards 203. In the example shown in Figs. 2A and 2B the evaporator 103 is configured to enable cooling of a stack of memory boards 203. A space is provided between adjacent memory boards 203 and sections of the evaporator 103 are configured to be fitted into the spaces between adjacent memory boards 203.

The evaporator 103 comprises a plurality of channels 201. The channels 201 are configured to enable flow of working fluid 113. The channels 201 can provide a conduit or a plurality of conduits for the working fluid 113 between the inlet manifold and the outlet manifold. In this example the inlet manifold is the downcomer 107 of a two-phase cooling system 101 and the outlet manifold is the riser 109 of the two-phase cooling system 101. In the examples of Figs. 2A and 2B the working fluid 113 flows through the channels 201 in the direction indicated by the arrows 209.

The plurality of channels 201 are configured to enable heat from one or more heat sources 111 to be transferred into the working fluid 113 within the plurality of channels 201. In the example of Figs. 2A and 2B the memory boards 203, and the components on the memory boards 203 provide the heat sources 111 (indicated in Fig.1). The plurality of channels 201 are sized and shaped so that they can be positioned close enough to the memory boards 203 to enable heat from the memory boards 203 to be transferred into the working fluid 113 within the channels 201.

The channels 201 can be flat, or substantially flat. The channels 201 can be shaped so that the height of the channels 201 is much less than the width of the channels 201. This can provide for efficient transfer of heat from the memory boards 203 into the working fluid 113 within the channels 201. This can also enable the plurality of channels 201 to be fitted into the gaps between adjacent memory boards 203.

The channels 201 can be sized so that they cover, or substantially cover, the surfaces of the memory boards 203. In some examples the channels 201 can be sized and shaped so that the surface area of the flat surface of the channels 201 covers, or substantially covers, the memory boards 203. This can enable heat from a plurality of different components on the memory boards 203 to be transferred into the working fluid 113.

In examples of the disclosure the plurality of channels 201 are expandable so that they can move between a non-expanded configuration and an expanded configuration. Fig. 2A shows the evaporator 201 with the plurality of channels 201 in the non-expanded configuration. In this example, in the non-expanded configuration the working fluid pressure is slightly higher than ambient pressure. In other examples, in the non-expanded configuration the working fluid pressure could be the same, or substantially the same, as the ambient pressure. Fig. 2B shows the plurality of channels 201 in the expanded configuration. In this example, in the expanded configuration the working fluid pressure is much higher than ambient pressure.

The external walls of the plurality of channels 201 can be configured to expand and contract to allow the plurality of channels 201 to move between the expanded and non-expanded configurations. The external walls of the plurality of channels 201 can be formed from any suitable material that enables the expansion of the plurality of channels 201.

As shown in Fig. 2A when the plurality of channels 201 are in the non-expanded configuration the plurality of channels 201 are sized so as to allow for movement of the evaporator 103 relative to the memory boards 203 or other heat sources 111. In this non-expanded configuration, a gap 207 is provided between the plurality of channels 201 and the memory boards 203. This gap 207 provides a clearance between the channels 201 and the memory boards 203 and allows the evaporator 103 to be inserted into position and/or removed from position adjacent to the memory boards 203.

When the evaporator 103 is in use, and thus is cooling the heat sources 111 on the memory boards 203, heat is transferred into the working fluid 113 within the plurality of channels 201. This increases the pressure of the working fluid 113 within the plurality of channels 201. When the internal pressure of the working fluid 113 is greater than the ambient temperature fluid pressure this will cause expansion of the channels 201. This causes the channels 201 to move from the non-expanded configuration shown in Fig. 2A to the expanded configuration shown in Fig. 2B.

As shown in Fig. 2B when the evaporator 103 is in the expanded configuration, the plurality of channels 201 are sized to ensure good heat transfer between the heat sources 111 of the memory boards 203 and the working fluid 113 flowing in the evaporator 103. The expanded channels 201 can also restrict movement of the evaporator 103 relative to one or more heat sources 111 and memory boards 203.

As shown in Fig. 2B there is no gap between the channels 201 and the memory boards 203 in the expanded configuration. In this configuration the channels 201 can be in direct contact with the memory boards so that the channels 201, or at least part of the channels, touch the memory boards 203. This causes the channels 201 to grip the memory boards 203 or other heat sources 111 and so restricts the movement of the evaporator 103 relative to the memory boards 203.

The channels 201 of the evaporator 103 can revert back to the non-expanded configuration. For example, if the memory boards 203 are not in use and heat is not being transferred into the working fluid 113 this will cause a drop in the pressure of the working fluid 113. This causes the channels 201 to contract back to the non-expanded configuration when the evaporator 103 is disconnected from the thermosyphon loop 101. This could then enable the evaporator 103 to be removed from the memory stack, for maintenance, repair or any other suitable purpose.

In the example shown in Figs. 2A and 2B a thermal interface material 205 is coupled to the plurality of channels 201. The thermal interface material 205 is coupled to the external walls of the channels 201 and therefore is provided between the memory boards 203 and the channels 201. The thermal interface material 205 can comprise a phase change material, a reworkable gad pad or any other suitable thermally conductive material.

The thermal interface material 205 can be provided over the flat, or substantially flat, surface of the channels 201 to provide good thermal conductivity across the surface area of the memory boards 203.

It is to be appreciated that the evaporator 103 can comprise components that are not shown in Figs. 2A and 2B. For example, the evaporator 103 can comprise an inlet header and/or an outlet header. The inlet header and outlet header can be configured to enable even flow distribution and stable heat transfer performance from the inlet to the outlet of the evaporator 103. The inlet header and outlet header can be designed to enable the evaporator 103 to meet power requirements and can take into account geometry and space constraints of the hardware being cooled. The inlet and outlet header of the evaporator 103 can have a circular, rectangular or any other cross-sectional area and/or shape. The evaporator 103 can have dedicated headers when cooling one heat source or shared headers when cooling multiple heat sources.

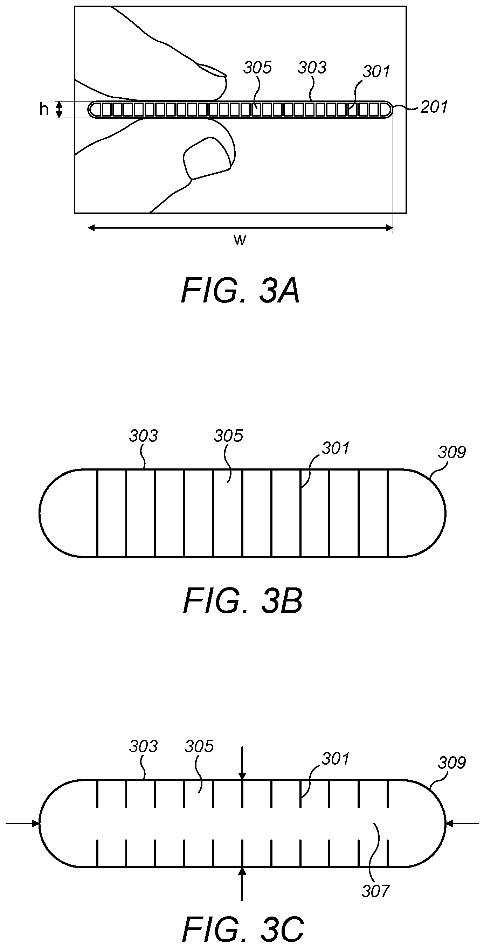

Figs. 3A to 3D show example channels 201 that could be used in the evaporators 103 illustrated in Figs. 2A and 2B or in any other suitable evaporators 103 or heat exchangers 200.

Fig. 3A shows an example of channel 201 that can be configured to be moved between an expanded and a non-expanded configuration. The channel 201 is flat, or substantially flat. The height "h" of the channel 201 is much less than the width "w" of the channel 201. This provides a low-profile channel 201 that can enable efficient heat transfer from the memory boards 203 or other heat sources 111 into the working fluid 113 within the channels 201. This can also enable the plurality of channels 201 to be fitted into the gaps in a stack of memory boards 203.

The channel 201 comprises an external wall 303. The external wall 303 provides a closed channel through which the working fluid 113 can flow. The external wall 303 can comprise a thermally conductive material to enable heat to be effectively transferred into the working fluid 113. The external wall 303 can also comprise a material that is flexible enough to allow the channel 201 to be moved between the non-expanded configuration and the expanded configuration. In some examples the external wall 303 can comprise copper, aluminum, brass or any other suitable material or combination of materials.

The channel 201 can also comprise a plurality of internal walls 301. The internal walls 301 extend vertically across the hight "h" of the channel 201. The internal walls 301 subdivide the channel 201 into a plurality of sub-channels 305. The sub-channels 305 provide more efficient flow of the working fluid 113 within the channel 201 due to the lower pressure drops and thus enable efficient heat transfer. In the example shown in Fig. 3A the internal walls 301 are distributed evenly across the width "w" of the channel so that the sub-channel 305 all have the same or similar sizes. In other examples different configurations of the internal walls 301 and sub-channels 305 could be used for optimizing, or substantially optimizing, the flow distribution.

Figs. 3B to 3D show how the channel 201 that can be configured to enable movement between a non-expanded configuration and an expanded configuration. Figs. 3B to 3D show a cross section of the channel 201 in different stages of fabrication.

Fig. 3B shows the cross section of the channel 201 as shown in Fig. 3A. In this example the channel 201 comprises a multiport tube. This channel 201 comprises external walls 303 and a plurality of internal channels 305 where the internal channels 305 are formed from internal walls 301. In Fig. 3B the channel 201 is in the expanded configuration.

In this expanded configuration the side edges 309 of the channel 201 have a convex shape so that the side edges 309 curve outwards.

In Fig. 3C the internal walls 301 are configured with means for enabling expansion of the internal walls 301 as the plurality of channels 201 are moved between the non-expanded configuration and the expanded configuration. In the example of Fig. 3A a section of the internal walls 301 is removed to create a gap 307 between sections of an internal wall 301. This gap 307 can allow movement of the lower section of the internal walls 301 relative to the upper section of the internal walls 301 and so allows for the expansion and contraction of the channel 201.

The gap 307 can be sized so as to allow for relative movement of the sections of the internal walls 301 while still providing for efficient flow of the working fluid 113 through the channel 201. The gaps 307 in the internal walls 301 can be formed using any suitable method.

Once the gaps 307 or other means for enabling expansion of the internal walls 301 are provided within the internal walls 301, forces can be applied to the channel 201 to cause contraction of the channel into the non-expanded configuration. In the example of Fig. 3B a horizontal force is applied at the side edges 309 of the channel 201 and a vertical force is applied at upper edges of the channel 201.

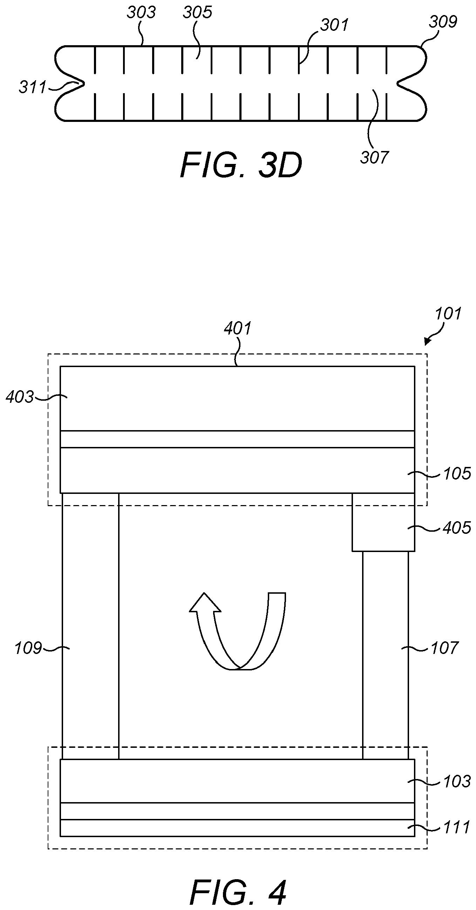

The applied forces cause the channel 201 to be contracted into the non-expanded configuration as shown in Fig. 3D. In this non-expanded configuration, the side edges of the channel 201 are provided into a folded configuration 311. This reduces the height of the channel 201 and provides a lower profile for the channel 201. When the channel 201 is in the non-expanded configuration the size of the gap 307 between sections of the internal walls 301 is decreased as the upper edges of the channel 201 are closer together.

When the channel 201 is in the configuration as shown in Fig. 3D it can be moved into position relative to memory boards or other similar heat sources 111. During hardware operation, heat from the source is transferred into the working fluid 113 within the channel 201 causing the increase in pressure within the working fluid which, in turn, causes expansion of the channel 201 back into an expanded configuration. In the expanded configuration the folded side edges are, at least partially, unfolded.

Fig. 4 shows an example two-phase cooling system 101 that can comprise an evaporator 103 with a plurality of channels 201 as shown in Figs. 2A to 3D. The two-phase cooling system 101 can be configured to be thermally coupled to a secondary cooling system. For example, the two phase-cooling system 101 can provide server-level cooling while the secondary cooling system can provide rack and/or room-level cooling. The two-phase cooling system 101 can be fluidically isolated from the secondary cooling system to enable the use of two different working fluids within the respective cooling systems. The two-phase cooling system 101 can be generally used for cooling any device that generates unwanted heat in a telecommunication system, computing system or in any other suitable type of system.

The two-phase cooling system 101 shown in Fig. 4 is a low-height thermosyphon loop. The thermal performance of the thermosyphon loop can be controlled by selecting an appropriate working fluid 113. The selection of an appropriate working fluid can be based on the trade-off between thermal performance, cost and robust operation.

The evaporator 103 of the two-phase cooling system 101 is thermally coupled to a heat source 111. The heat source 111 could comprise one or more memory boards 203 and/or any other suitable heat generating components such as CPUs, GPUs, TPUs, or any other suitable components. The evaporator 103 can comprise a plurality of expandable channels 201 or wick structures, micro-channels, arrays of evaporator fins, a serpentine arrangement of macro-/micro-channels or any suitable combination of such features. These are not shown in Fig. 4 for clarity, however they can be incorporated in the evaporator 103.

The evaporator 103 is coupled between the downcomer 107 and the riser 109 of the two-phase cooling system 101 so that the working fluid 113 can flow from the downcomer 107 through the channels 201 of the evaporator 103 and into the riser 109 as indicated by the arrow.

The two-phase cooling system 101 also comprises an intermediate heat exchanger 401. The intermediate heat exchanger 401 enables the two-phase cooling system to be coupled to a secondary cooling system. The intermediate heat exchanger 401 can comprise means that enables heat from the two-phase cooling system 101 to be transferred to a secondary cooling system. The secondary cooling system can be an air-cooled or a liquid-cooled system.

In the example of Fig. 4 the intermediate heat exchanger 401 comprises a condenser 105 and a rack-level evaporator 403. In the intermediate heat exchanger 401, the working fluid 113 from the two-phase cooling system 101 is condensed by the condenser 105 on the primary side. This causes heat to be transferred to the rack-level evaporator 403 on the secondary side of the intermediate heat exchanger 401.

The rack-level evaporator 403 forms part of a rack-level cooling loop. The rack-level cooling loop can be an active single-phase or two-phase cooling system, or another passive two-phase cooling system as shown in Fig. 1. As mentioned above, the thermosyphon loop and rack-level cooling systems can have the same type working fluid 113 or different types of working fluids 113.

The intermediate heat exchanger 401 can be positioned directly above the evaporator 103 as shown in Fig. 4. In other examples the intermediate heat exchanger 401 can be positioned in a different position. The position of the intermediate heat exchanger 401 relative to the evaporator 103 can be determined by the hardware that is being cooled. The location of the intermediate heat exchanger 401 relative to the evaporator 103 dictates the geometry (diameter and length) of the downcomer 107 and riser 109.

The condenser 105 is coupled between the riser 109 and the downcomer 107. In this example the condenser 105 is a low-profile condenser 105 so that it has a flat, or substantially flat, shape. In this example the condenser 105 also comprises a reservoir 405. The reservoir 405 can be configured to store working fluid 113 and optimize, or substantially optimize, thermal performance. The reservoir 405 can be machined directly in the outlet header of the condenser 105 or incorporated along the downcomer 107. The reservoir can have a circular, rectangular or any other cross-sectional area and/or shape.

The rack-level evaporator 403 can comprise any means that enables heat to be transferred from the condenser 105 to a secondary cooling system. The condenser 105 can comprise a plurality of wick structures, micro-channels, arrays of evaporator fins, a serpentine arrangement of macro-/micro-channels or any suitable combination of such features.

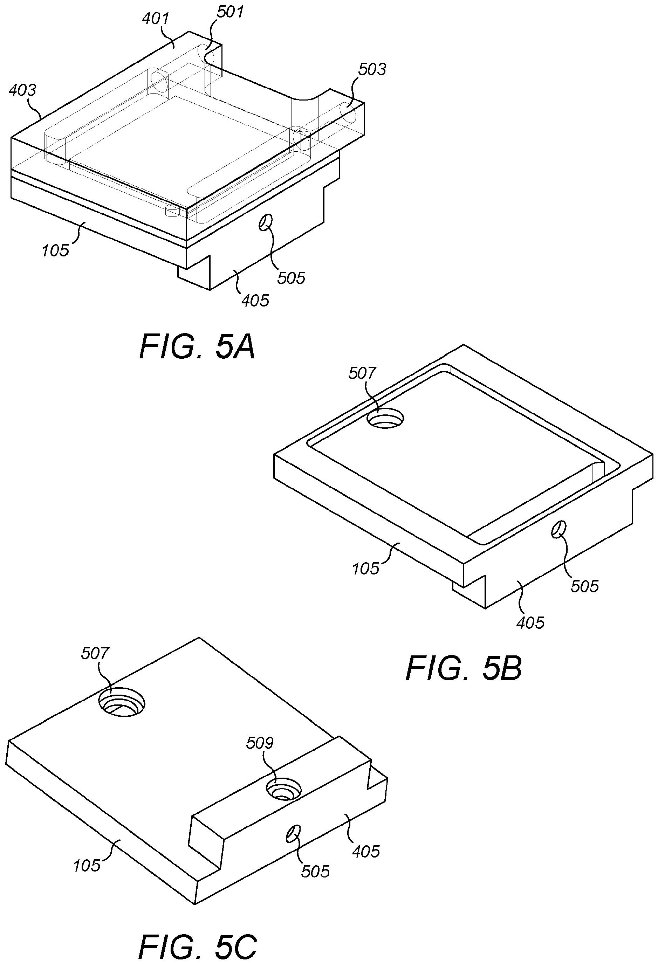

Figs. 5A to 5C show an example condenser 105 in more detail. The example condensers 105 could be provided within a two-phase cooling system 101 as shown in Fig. 4 or within any other suitable type of cooling system.

Fig. 5A shows the intermediate heat exchanger 401 comprising the condenser 105 and the rack-level evaporator 403, Fig. 5B shows a top view of the condenser 105 and Fig. 5C shows a bottom view of the condenser 105.

In the example of Fig. 5A the rack-level evaporator 403 comprises an inlet 501 and an outlet 503. The inlet 501 and the outlet 503 are provided on opposing sides of the rack-level evaporator 403 so as to enable working fluid 113 to flow through the rack-level evaporator 403. In the example of Fig. 5A the inlet 501 and the outlet 503 are configured to extend in a horizontal direction so as to allow for flow of the working fluid 113 in a horizontal direction. This also provides the rack-level evaporator 403 with a low profile which reduces the form factor of the intermediate heat exchanger 401. The profile provides a more versatile cooling system that can be used with a wider range of devices. Other configurations and arrangements for the inlet tube 501 and outlet tube 503 can be used depending on the hardware that is to be cooled.

The condenser 105 also comprises an inlet port 507 and an outlet port 509 for the flow of working fluid 113.

The condenser 105 comprises a reservoir 405 for storing working fluid 113. In the examples of Figs. 5A to 5C the reservoir 405 is coupled to an outlet header of the condenser 105. Positioning the reservoir 405 in the outlet header of the condenser 105 rather than within the downcomer 107 can make the cooling system 101 easier to fabricate. Positioning the reservoir 405 in the outlet header also ensures that the reservoir 405 is in the highest position within the cooling system 101 providing optimal thermal performance. Figs. 5A to 5C also show that the reservoir 405 can be designed with a filling port 505 in order to charge the cooling system 101 before operation.

The reservoir 405 of the condenser 105 can reduce sub-cooling of the working fluid 113. This can help to prevent flooding of the condenser 105 which would reduce the thermal efficiency of the cooling systems.

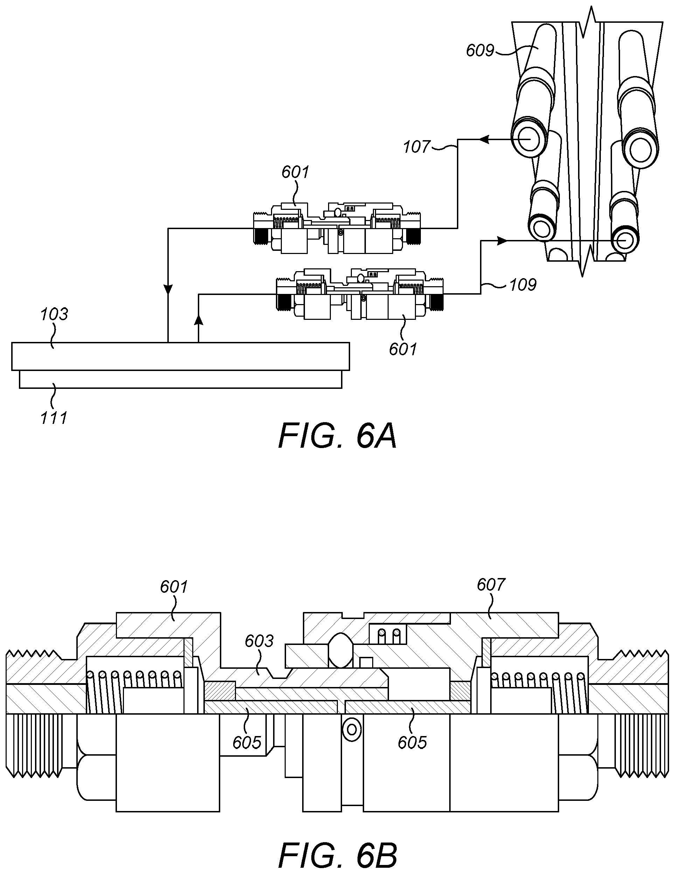

Fig. 6A shows an evaporator 103 coupled to a rack manifold 609. The rack manifold 609 enables the evaporator 103 to be fluidically coupled to a condenser 105 and other components of a cooling system. The evaporator 103 could comprise a plurality of channels 201 as shown in Figs 2A to 3D or could be manufactured with any other suitable type of structures to enhance heat transfer. The evaporator 103 can be thermally coupled via a thermal interface material (not shown in Fig. 6A) to a heat source 111. The heat source could be a memory board 203, heat generating components such as CPUs, GPUs, TPUs, or any other suitable heat sources.

The evaporator 103 is coupled to the rack manifold 609 that comprises a downcomer 107 and a riser 109. The downcomer 107 and the riser 109 are configured so as to allow for the flowing of working fluid 113 between the condenser 105 (not shown in Fig. 6A) and the evaporator 103.

In the example shown in Fig. 6A means for removably coupling the evaporators 103 to the rack manifold 609 are provided in both the downcomer 107 and the riser 109. In this example the means are represented by quick couplings provided in both the downcomer 107 and the riser 109. Other means and/or type of couplings could be used in other examples of the disclosure. The means could enable the evaporator 103 to be removed from the rest of the cooling system 101 while the hardware is in use. This can provide for a hot-swappable evaporator 103 or other heat exchangers 200.

The quick couplings 601 that can be used are schematically shown in more detail in Fig. 6B. The quick couplings 601 comprise an adapter plug 603, a valve 605 and a housing 607. Depending on the operating conditions and system geometry the quick couplings can be either blind-mate or hand-mate.

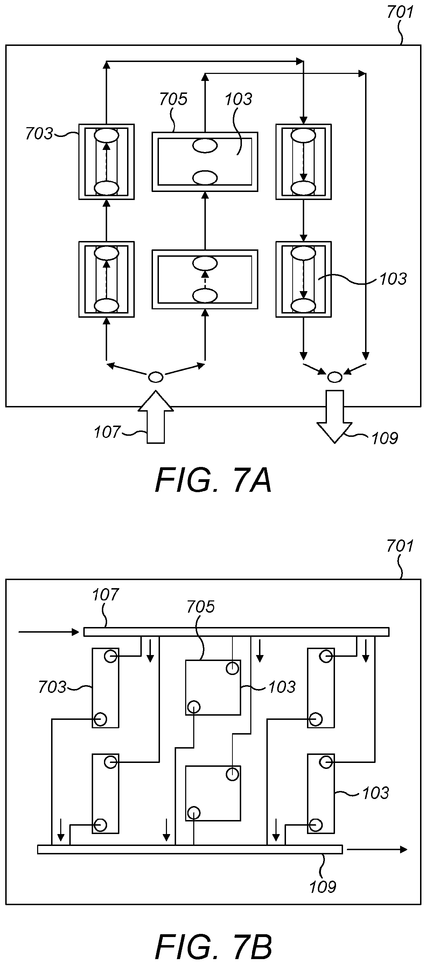

Figs. 7A and 7B schematically show the layout of a cooling system for multiple components to be cooled within a targeted hardware 701. The cooling system can use passive two-phase flow as shown in Fig.1 The cooling system comprises a plurality of evaporators 103 comprising a plurality of channels 201 as shown in Figs. 2A to 3D. In some examples the evaporators 103 can comprise wick structures, micro-channels, arrays of evaporator fins a serpentine arrangement of macro-/micro-channels or any suitable combination of such features.

In the example of Figs. 7A and 7B the hardware 701 comprises memory units 703 and processing units 705. In this example the hardware 701 comprises four memory units 703 and two processing units 705. Other arrangements and configurations of the components in the hardware 701 could be used in other examples of the disclosure.

The memory units 703 can comprise stacks of memory boards 203. The expandable channels 201 of the evaporators 103 can be fitted into gaps between adjacent memory boards 203. This can provide efficient cooling of the memory boards 203. Additional evaporators 103 can also be provided on the processing units 705.

In the example of Fig. 7A the two-phase cooling system 101 is configured so that the evaporators 103 are connected in series. The evaporators 103 are connected in series so that working fluid 113 from the outlet of a first evaporator 103 is then provided to the inlet of the next evaporator 103 within the series. In this series arrangement the working fluid 113 passes through each of evaporators 103 sequentially.

In the example shown in Fig. 7A the two-phase cooling system 101 comprises two series loops. A first series loop comprises the evaporators 103 for cooling the memory units 703 and a second series loop comprises the evaporator 103 for cooling the processing units 705. Depending on the hardware configuration and thermal design power of the different components, other arrangements could be used in other examples of the disclosure.

In the example of Fig. 7B the two-phase cooling system 101 is configured so that the evaporators 103 are connected in parallel. The evaporators 103 are connected in parallel so that the inlets and the outlets of each evaporator 103 share common server-level manifolds. In this example the server-level inlet manifold has the working fluid 113 coming from the downcomer 107, while the server-level outlet manifold has the working fluid 113 going to the riser 109. Depending on the hardware configuration and thermal design power of the different components, other arrangements could be used in other examples of the disclosure.

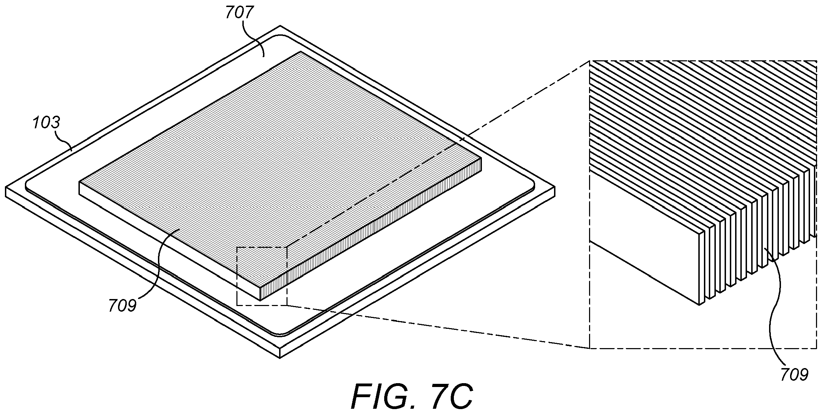

Fig. 7C shows an example evaporator 103 that can be used in cooling systems operating in single- and two-phase flow, as well as in active and passive mode. For example, it could be used in the two-phase cooling system 101 of Figs. 7A and 7B.

The example evaporator 103 comprises a base plate 707 and a plurality of evaporator fins 709. The evaporator 103 would also comprise a cover plate (not shown in Fig. 7C) arranged to cover the base plate 707 and evaporator fins 709.

The base plate 707 comprises a flat or substantially flat surface. The base plate 707 can comprise a thermally conductive material. When the evaporator 103 is in use the base plate 707 can be thermally coupled to a heat source to enable heat to be transferred from the heat source into working fluid 113 within the evaporator 103.

The plurality of evaporator fins 709 extend out of the surface of the base plate 707. The evaporator fins 709, at least partially, define flow paths for the working fluid 113 through the evaporator 103.

In the example of Fig. 7C the evaporator fins 709 comprise elongate structures that extend perpendicularly, or substantially perpendicularly, out of the base plate 707. In the example shown in Fig. 7C the evaporator fins 709 comprise elongate plates that extend in parallel, or substantially parallel, across the surface of the base plate 707.

The evaporator fins 709 can comprise any suitable thermally conductive material. The evaporator fins 709 can comprise the same material as the base plate 707 and the cover plate.

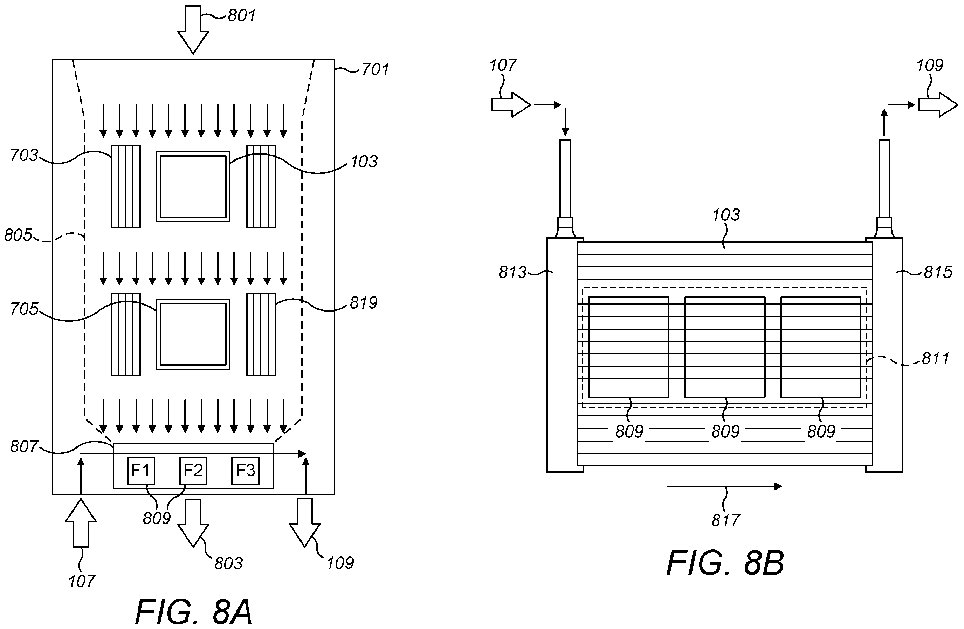

Figs. 8A and 8B show another cooling system arrangement that could be used for the cooling of a targeted hardware 701. In this example the hardware 701 comprises four memory units 703 and two processing units 705. Other hardware configurations701 could be used in other examples of the disclosure.

In the example hardware 701 shown in Fig. 8A evaporators 103 are provided on the processing units 705, while the memory units 703 and other low-power components on the server board are cooled via air-cooling heat sinks 819. The evaporators 103 could comprise a plurality of wick structures, micro-channels, arrays of evaporator fins, a serpentine arrangement of macro-/micro-channels or any suitable combination of such features. Fig. 7C shows example micro-channels that can be used.

The hardware 701 shown in Fig. 8A comprises a hybrid cooling system, as the two processing units 705 are two-phase cooled, while the other components, such as the memory units 703, board, and secondary chips, are cooled by an air-cooling system.

The air-cooling system is configured to draw in cold air at the front of the hardware 701 as indicated by the arrow 801. The air then flows through the different air-cooling heat sinks 819 located on the hardware components and it increases its temperature thanks to the heat dissipation from the memory units 703 and other heat sources 111. The heated air is then expelled from the back of the hardware 701 as indicted by the arrow 803.

In the example shown in Fig. 8A the hardware 701 comprises a baffle 805. The baffle 805 can be an adjustable baffle and is provided around the memory units 703 and other heat sources 111. The baffle 805 provides means for directing the air flow over the memory units 703 and other air-cooled components in order to reduce pressure drop and maximize, or substantially maximize, the heat transfer provided by the air cooling. The arrows and baffle shown in Fig. 8A show a uniform air flow over the hardware components. In other examples additional baffles, or other means for guiding air flow, can be installed in the hardware 701 so as to provide for increased air flow over the air-cooled components compared to other components, which can be two-phase cooled or do not require specific cooling. Control of the air flow can be beneficial to improve energy efficiency and reduce noise level.

A plurality of fans 809 are also provided at the rear of the hardware 701. The plurality of fans 809 are configured to draw the air through the hardware 701. In the example of Fig. 8A, three fans 809 are provided. Other numbers of fans, locations of fans and air flow directions can be used in other examples of the disclosure.

In the example of Fig. 8A the hardware 701 also comprises an additional cooling system 807. In this example the additional cooling system 807 can comprise a passive two-phase cooling system 101 as shown in Fig. 1. The additional cooling system 807 is configured to enable cooling of the heated air that has been drawn over the memory units 703 and any other air-cooled components. The two-phase cooling system is therefore configured to enable heat to be recovered from the air-cooling system. The additional cooling system 807 is provided at the rear of the hardware 701 so that the air from the air-cooling system can be cooled before exiting the hardware 701 and entering the surrounding environment.

The additional cooling system 807 can comprise an evaporator 103 positioned between a downcomer 107 and a riser 109. Fig. 8B shows a section of the additional cooling system 807 and evaporator 103 in more detail. The evaporator 103 can be connected to a rack manifold as described above or by using any other suitable connection.

The evaporator 103 of the additional cooling system 807 is provided at the rear of the hardware 701 and comprises an inlet 813 that is coupled to the downcomer 107. The inlet 813 enables the single-phase working fluid 113 to be provided to the evaporator 103.

The working fluid 113 flows through the evaporator 103 as indicated by the arrow 817. This causes the working fluid 113 to be heated by the air that is drawn across the evaporator 103. The air can be drawn across the evaporator 103 by the plurality of fans within the fan tray 811. In this example three fans 809 are provided within the fan tray 811. Other numbers of fans 809, locations of fans and air flow directions can be used in other examples of the disclosure.

Due to the heat transfer between the heated air and the working fluid 113, the working fluid 113 is partially boiled and the two-phase working fluid 113 is then expelled from the evaporator 807 through the outlet 815 and provided to the riser 109.

The additional cooling system 807 therefore enables additional heat to be removed from the data centre 701. This heat could be recovered and transferred elsewhere for heating or reused in waste heat recovery applications. This can provide for more energy efficient hardware 701. The example shown in Figs. 8A and 8B is suitable for use in datacenters, and other hardware environments, that operate with traditional cooling methods, such as direct expansion, chilled water, evaporative free cooling, or any other traditional cooling method.

The additional cooling system 807 can also help to mitigate hot spots that can appear when upgrading hardware with additional IT, telecom and computing capabilities in existing datacenters in which room-level cooling infrastructures have been sized for a given cooling capacity.

In the example shown in Figs. 8A and 8B the cooling system 807 is shown as being provided in addition to the evaporators 103 used on the processing units 705. In other examples the additional cooling system 807 could be provided in hardware 701 without these primary evaporators 103 or in any other suitable configuration.

In the example shown in Figs. 8A and 8B the additional cooling system 807 is configured to cool the air before it is expelled from the hardware 701 into the surrounding environment. In other examples the additional cooling system 807 can be configured to enable the cooled air to be recirculated within the hardware 701 rather than exiting the hardware 701. In such examples, baffles or any other suitable means for guiding air flow can be provided within the hardware 701. Recirculating the air within the hardware 701 can reduce the heat expelled into the environment surrounding the hardware 701 and can allow more efficient cooling and reduced overall energy consumption.

The term 'comprise' is used in this document with an inclusive not an exclusive meaning. That is any reference to X comprising Y indicates that X may comprise only one Y or may comprise more than one Y. If it is intended to use `comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or `for example' or 'can' or 'may' in the text denotes, whether explicitly stated or not, that such features or functions are present in at least the described example, whether described as an example or not, and that they can be, but are not necessarily, present in some of or all other examples. Thus `example', `for example', `can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of `at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

## Claims

1. A heat exchanger (200) comprising:
a plurality of channels (201) configured for flow of working fluid wherein the plurality of channels (201) are configured to move between a non-expanded configuration and an expanded configuration such that, in the non-expanded configuration the plurality of channels (201) are sized so as to allow for movement of the heat exchanger (200) relative to one or more heat sources (203) and in the expanded configuration the plurality of channels (201) are sized so as to restrict movement of the heat exchanger (200) relative to the one or more heat sources (203), wherein the plurality of channels (201) are configured so that changes in internal pressure of the working fluid causes the plurality of channels (201) to move between the non-expanded configuration and the expanded configuration,
**characterised in that**
the plurality of channels (201) comprise a plurality of internal walls (301) configured to provide a plurality of sub-channels (305) and wherein the plurality of internal walls (301) comprise means for enabling expansion of the internal walls (301) as the plurality of channels (201) are moved between the non-expanded configuration and the expanded configuration.

2. A heat exchanger (200) as claimed in claim 1 wherein the plurality of channels (201) are substantially flat.

3. A heat exchanger (200) as claimed in any preceding claim wherein the plurality of channels (201) are configured to fit between substantially flat heat sources (203).

4. A heat exchanger (200) as claimed in any preceding claim wherein the heat exchanger (200) is configured so that when the plurality of channels (201) are in the non-expanded configuration and positioned between the one or more heat sources (203) a gap is provided between the heat sources (203) and the plurality of channels (201).

5. A heat exchanger (200) as claimed in any preceding claim wherein the heat exchanger (200) is configured so that when the plurality of channels (201) are in the expanded configuration and positioned between the one or more heat sources (203) the plurality of tubes grip the heat sources (203).

6. A heat exchanger (200) as claimed in any preceding claim wherein a thermal interface material is coupled to the plurality of channels (201).

7. A heat exchanger (200) as claimed in any preceding claim comprising at least one header configured to enable cooling of one or more heat sources (203).

8. A cooling system comprising a plurality of heat exchangers (200) as claimed in any of claims 1 to 7.

9. A cooling system as claimed in claim 8 for cooling hardware components.

10. A cooling system as claimed in any of claims 8 to 9 wherein the cooling system comprises one or more intermediate heat exchangers (200) comprising a reservoir for storing working fluid.

11. A cooling system as claimed in claim 10 wherein the reservoir is coupled to an outlet of the intermediate heat exchanger (200).

12. A cooling system as claimed in any of claims 8 to 11 wherein the heat exchangers (200) are removably coupled to the cooling system.

13. A cooling system as claimed in any of claims 8 to 12 wherein the cooling system is coupled to an air-cooling system.

14. A cooling system as claimed in claim 13 wherein the air-cooling system comprises one or more fans configured to drive air flow through the air-cooling system towards a two-phase cooling system.

## Patentansprüche

1. Wärmetauscher (200), umfassend:
eine Vielzahl von Kanälen (201), die für den Durchfluss eines Arbeitsfluids konfiguriert sind, wobei die Vielzahl von Kanälen (201) konfiguriert ist, um sich zwischen einer nicht expandierten Konfiguration und einer expandierten Konfiguration zu bewegen, so dass in der nicht expandierten Konfiguration die Vielzahl der Kanäle (201) so bemessen ist, dass der Wärmetauscher (200) relativ zu einer oder mehreren Wärmequellen (203) bewegt werden kann,
und in der expandierten Konfiguration die Vielzahl der Kanäle (201) so bemessen ist, dass die Bewegung des Wärmetauschers (200) relativ zu der einen oder den mehreren Wärmequellen (203) eingeschränkt wird, wobei die Vielzahl von Kanälen (201) so konfiguriert ist, dass Änderungen des Innendrucks des Arbeitsfluids dazu führen, dass sich die Vielzahl der Kanäle (201) zwischen der nicht expandierten Konfiguration und der expandierten Konfiguration bewegt,
**dadurch gekennzeichnet, dass**
die Vielzahl von Kanälen (201) eine Vielzahl von Innenwänden (301) umfasst, die konfiguriert sind, um eine Vielzahl von Unterkanälen (305) zu bilden, und wobei die Vielzahl von Innenwänden (301) Mittel umfasst, die eine Ausdehnung der Innenwände (301) ermöglichen, wenn die Vielzahl von Kanälen (201) zwischen der nicht expandierten Konfiguration und der expandierten Konfiguration bewegt wird.

2. Wärmetauscher (200) nach Anspruch 1, wobei die Vielzahl der Kanäle (201) im Wesentlichen flach ist.

3. Wärmetauscher (200) nach einem der vorstehenden Ansprüche, wobei die Vielzahl von Kanälen (201) konfiguriert ist, um zwischen im Wesentlichen flache Wärmequellen (203) zu passen.

4. Wärmetauscher (200) nach einem der vorstehenden Ansprüche, wobei der Wärmetauscher (200) konfiguriert ist, so dass, wenn sich die Vielzahl von Kanälen (201) in der nicht expandierten Konfiguration befindet und zwischen der einen oder den mehreren Wärmequellen (203) angeordnet ist, ein Spalt zwischen den Wärmequellen (203) und der Vielzahl von Kanälen (201) vorgesehen ist.

5. Wärmetauscher (200) nach einem der vorstehenden Ansprüche, wobei der Wärmetauscher (200) konfiguriert ist, so dass, wenn sich die Vielzahl von Kanälen (201) in der erweiterten Konfiguration befindet und zwischen der einen oder den mehreren Wärmequellen (203) positioniert ist, die Vielzahl von Rohren die Wärmequellen (203) einklemmt.

6. Wärmetauscher (200) nach einem der vorstehenden Ansprüche, wobei ein thermisches Schnittstellenmaterial mit der Vielzahl von Kanälen (201) verbunden ist.

7. Wärmetauscher (200) nach einem der vorhergehenden Ansprüche, umfassend mindestens einen Kopf, der konfiguriert ist, um die Kühlung einer oder mehrerer Wärmequellen (203) zu ermöglichen.

8. Kühlsystem, umfassend eine Vielzahl von Wärmetauschern (200) nach einem der Ansprüche 1 bis 7.

9. Kühlsystem nach Anspruch 8 zur Kühlung von Hardwarekomponenten.

10. Kühlsystem nach einem der Ansprüche 8 bis 9, wobei das Kühlsystem einen oder mehrere Zwischenwärmetauscher (200) umfasst, die ein Reservoir zur Speicherung von Arbeitsfluid umfassen.

11. Kühlsystem nach Anspruch 10, wobei das Reservoir mit einem Auslass des Zwischenwärmetauschers (200) verbunden ist.

12. Kühlsystem nach einem der Ansprüche 8 bis 11, wobei die Wärmetauscher (200) abnehmbar mit dem Kühlsystem verbunden sind.

13. Kühlsystem nach einem der Ansprüche 8 bis 12, wobei das Kühlsystem mit einem Luftkühlsystem gekoppelt ist.

14. Kühlsystem nach Anspruch 13, wobei das Luftkühlsystem einen oder mehrere Ventilatoren umfasst, die konfiguriert sind, um einen Luftstrom durch das Luftkühlsystem in Richtung eines Zweiphasenkühlsystems anzutreiben.

## Revendications

1. Échangeur de chaleur (200) comprenant :
une pluralité de canaux (201) configurés pour l'écoulement d'un fluide actif dans lequel la pluralité de canaux (201) sont configurés pour se déplacer entre une configuration non dilatée et une configuration dilatée de telle sorte que, dans la configuration non dilatée, la pluralité de canaux (201) sont dimensionnés de manière à permettre un déplacement de l'échangeur de chaleur (200) par rapport à une ou plusieurs sources de chaleur (203) et dans la configuration dilatée, la pluralité de canaux (201) sont dimensionnés de manière à limiter un déplacement de l'échangeur de chaleur (200) par rapport aux une ou plusieurs sources de chaleur (203), dans lequel la pluralité de canaux (201) sont configurés de telle sorte que des changements de pression interne du fluide actif amènent la pluralité de canaux (201) à se déplacer entre la configuration non dilatée et la configuration dilatée,
**caractérisé en ce que**
la pluralité de canaux (201) comprennent une pluralité de parois internes (301) configurées pour fournir une pluralité de sous-canaux (305) et dans lequel la pluralité de parois internes (301) comprennent un moyen pour permettre une dilatation des parois internes (301) quand la pluralité de canaux (201) se déplacent entre la configuration non dilatée et la configuration dilatée.

2. Échangeur de chaleur (200) selon la revendication 1 dans lequel la pluralité de canaux (201) sont sensiblement plats.

3. Échangeur de chaleur (200) selon une quelconque revendication précédente dans lequel la pluralité de canaux (201) sont configurés pour s'adapter entre des sources de chaleur (203) sensiblement plates.

4. Échangeur de chaleur (200) selon une quelconque revendication précédente dans lequel l'échangeur de chaleur (200) est configuré de telle sorte que, lorsque la pluralité de canaux (201) sont dans la configuration non dilatée et positionnés entre les une ou plusieurs sources de chaleur (203), un espace est prévu entre les sources de chaleur (203) et la pluralité de canaux (201).

5. Échangeur de chaleur (200) selon une quelconque revendication précédente dans lequel l'échangeur de chaleur (200) est configuré de telle sorte que, lorsque la pluralité de canaux (201) sont dans la configuration dilatée et positionnés entre les une ou plusieurs sources de chaleur (203), la pluralité de tubes saisissent les sources de chaleur (203).

6. Échangeur de chaleur (200) selon une quelconque revendication précédente dans lequel un matériau d'interface thermique est couplé à la pluralité de canaux (201).

7. Échangeur de chaleur (200) selon une quelconque revendication précédente comprenant au moins un collecteur configuré pour permettre le refroidissement d'une ou plusieurs sources de chaleur (203).

8. Système de refroidissement comprenant une pluralité d'échangeurs de chaleur (200) selon l'une quelconque des revendications 1 à 7.

9. Système de refroidissement selon la revendication 8 pour le refroidissement de composants matériels.

10. Système de refroidissement selon l'une quelconque des revendications 8 à 9 dans lequel le système de refroidissement comprend un ou plusieurs échangeurs de chaleur intermédiaires (200) comprenant un réservoir destiné à stocker un fluide actif.

11. Système de refroidissement selon la revendication 10 dans lequel le réservoir est couplé à une sortie de l'échangeur de chaleur intermédiaire (200).

12. Système de refroidissement selon l'une quelconque des revendications 8 à 11 dans lequel les échangeurs de chaleur (200) sont couplés de manière amovible au système de refroidissement.

13. Système de refroidissement selon l'une quelconque des revendications 8 à 12 dans lequel le système de refroidissement est couplé à un système de climatisation.

14. Système de refroidissement selon la revendication 13 dans lequel le système de refroidissement comprend un ou plusieurs ventilateurs configurés pour entraîner un flux d'air à travers le système de climatisation vers un système de refroidissement à deux phases.
